# DEMANDE DE BREVET EUROPEEN

(11) **EP 1 865 551 A2**
(43) Date de publication de la demande: **12.12.2007**
(21) Numéro de dépôt: 07108925.4
(22) Date de dépôt: 25.05.2007
(51) Int. Cl.: H01L 21/762

(54) **Procédé de limitation de diffusion en mode lacunaire dans une hétérostructure**

(30) Priorité: 09.06.2006 FR 0652083
(71) Demandeur: S.O.I. TEC Silicon on Insulator Technologies, 38190 Bernin (FR)
(72) Inventeur: Hebras, Xavier, 38000, Grenoble (FR)
(74) Mandataire: Desormiere, Pierre-Louis

(57) **Abrégé**

L'invention concerne un procédé de fabrication d'une hétérostructure comprenant au moins une première couche (102) en matériau semi-conducteur sur une deuxième couche (101) en un matériau différent de celui de la première couche. Pour empêcher des éléments du matériau semi-conducteur de diffuser dans la première couche (102) et dans les couches adjacentes en mode lacunaire, le procédé de l'invention comprend une étape d'enrichissement (S2) en défauts interstitiels (105a) de la première couche (102) de manière à limiter la diffusion en mode lacunaire des éléments de la première couche.

## Description

### Domaine technique et art antérieur

La présente invention concerne le domaine des plaques de semi-conducteurs, également dénommées "wafer". L'invention concerne plus particulièrement les plaques de semi-conducteurs réalisées à partir d'hétérostructures comprenant une première couche en matériau semi-conducteur sur une deuxième couche ou un substrat en un autre matériau en générale isolant. De telles hétérostructures peuvent être, par exemple, de type SiGe/Si, c'est-à-dire comprendre une couche de silicium-germanium (SiGe) sur un substrat de silicium.

Dans le cas d'une hétérostructure de type SiGe/Si, celle-ci peut être utilisée directement pour former une couche de matériau semi-conducteur comme par exemple dans une structure de type SiGeOI (silicium-germanium (SiGe) sur isolant) ou être utilisée comme couche d'épitaxie notamment pour former une couche de silicium contraint comme lors de la réalisation d'une structure de type sSOI (silicium contraint sur isolant).

Les hétérostructures de type SiGe/Si ou comportant une couche de silicium contraint (sSi) présentent aujourd'hui un intérêt de plus en plus marqué dans le domaine des semi-conducteurs. En effet, de telles structures, grâce à la présence du germanium ou alors du fait de la contrainte de la matière, présentent des caractéristiques électriques plus intéressantes que des structures standards réalisées en silicium. La qualité des films en surface de ces structures semi-conductrices est d'une très grande importance. En particulier, l'absence de défauts et de contaminants à leur surface ou alors dans leur épaisseur sont des paramètres à optimiser, en vue de la fabrication des futurs composants.

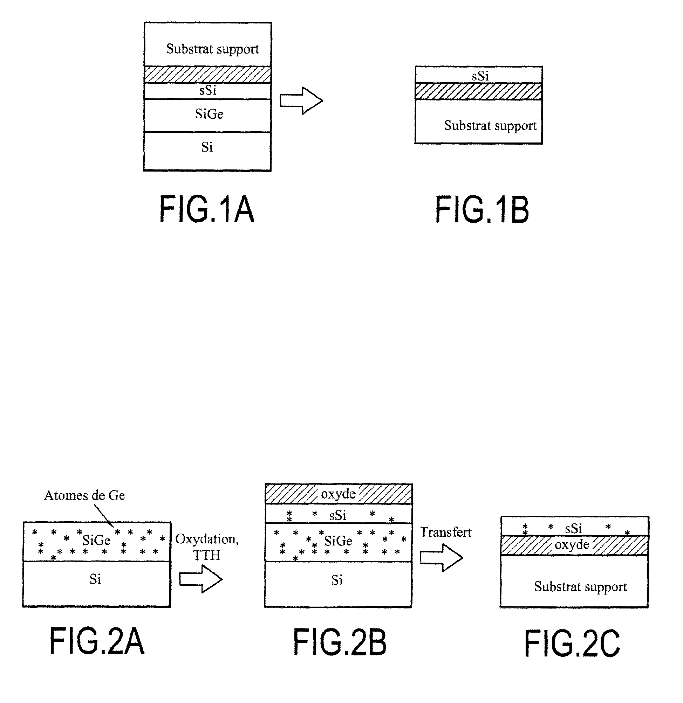

Dans le cas par exemple de la fabrication d'un substrat de type sSOI selon la technologie Smart Cut™ (notamment décrite dans le document US 5 374 564 ou dans l'article de A.J. Auberton-Hervé et al. intitulé "Why can Smart-Cut Change the future of microelectronics ?", Int. Journal of High Speed Electronics and Systems, Vol.10, No1, 2000, p.131-146), une première opération consiste à réaliser un substrat donneur formé par une hétérostructure de type Si/SiGe/sSi (figure 1A). La fabrication du substrat donneur comprend, après croissance d'une couche de SiGe tampon sur un substrat support en silicium, la réalisation d'une couche en SiGe relaxée par l'intermédiaire de la couche tampon de SiGe. On forme ensuite une couche de silicium contraint (sSi) sur la couche de SiGe relaxée. La concentration en Ge dans la couche relaxée est typiquement de l'ordre de 20%, mais elle peut atteindre jusqu'à 100% suivant le degré de contrainte désiré dans le film de silicium.

Une fois la couche de sSi formée et conformément à la technologie Smart Cut™, on implante des espèces atomiques dans la couche de SiGe relaxée au niveau d'une zone d'implantation et on met en contact intime la face de la couche de sSi avec un substrat support (en général un substrat de Si). On réalise ensuite un clivage de la couche de SiGe au niveau de la zone d'implantation pour transférer la partie située entre la surface soumise à l'implantation et la zone d'implantation (i.e. la couche de sSi et une partie de la couche de SiGe relaxée) sur le substrat receveur.

Après retrait du reliquat de SiGe subsistant au-dessus de la couche de sSi, on obtient ainsi une structure sSOI avec une couche de sSi sur une face du substrat support (figure 1B).

La réalisation de structure sSOI selon la technologie Smart Cut™ est notamment décrite dans le document US 6 953 736.

Ce type de procédé de fabrication met en oeuvre des traitements qui entraînent des dégradations résultant de la diffusion d'éléments de germanium au sein de la structure (figures 2A à 2C). En effet, on a observé que les traitements thermiques qui interviennent lors de la formation sur le substrat donneur de la couche de silicium contraint et de la couche d'oxyde (figure 2B) et/ou lors du transfert des couches de sSi et SiGe (figure 2C), contribuent à la diffusion d'éléments de germanium dans la couche de silicium contraint. La technologie Smart Cut™ impose des traitements thermiques comme par exemple la densification de l'oxyde déposé, le traitement thermique de "splitting" ou de fragilisation, les éventuels traitements thermiques post "splitting" qui précèdent la gravure (pré-stabilisation de renforcement de l'interface de collage à environ 800°C durant plusieurs heures). Ces traitements thermiques sont importants et ne peuvent pas être limités pour éviter la diffusion des éléments de germanium en particulier sa concentration dépasse 20%.

La diffusion d'une fraction des éléments de germanium de la couche de SiGe dans la couche de sSi entraîne un manque de démarcation entre la couche de SiGe et celle de sSi, ce qui entraîne des problèmes pour effectuer des gravures sélectives. En conséquence, le passage d'une zone de SiGe à une zone de silicium (ex. changement de concentration en Ge allant de 40% à 0%) ne se fait pas de manière abrupte mais s'étend sur une certaine épaisseur par diffusion du germanium dans la couche de silicium contraint adjacente.

Aussi, la gravure sélective du germanium au niveau de cette couche doit être prolongée sur une longue durée afin de retirer tout le germanium présent. Ce prolongement excessif de la gravure conduit à la formation d'une surface rugueuse post gravure, voire même à la formation de défauts HF, car le retrait de toute la zone transitoire contenant du germanium conduit à surgraver la couche de silicium contraint, en particulier au niveau des défauts ou zone de faiblesses (dislocations, défauts cristallins, impuretés ou contaminants, non uniformités d'épaisseur) dans la couche transférée (on appelle défauts "HF" les défauts dans la couche active semi-conductrice de la structure sSOI, ici la couche de sSi, qui s'étendent à partir de la surface de cette couche jusque dans l'oxyde enterré et dont la présence peut être révélée par une auréole de décoration après traitement dans un bain d'acide fluorhydrique (HF)).

En raison de la finesse de la couche active de silicium contraint (de l'ordre de 200 Å pour du SiGe à 20% de Ge), il est important de pouvoir contrôler avec une grande précision la qualité de cette couche.

Des travaux ont montré qu'il existe une relation directe entre la diffusion des espèces au sein de structures en SiGe et la présence de défauts ponctuels de type lacunes et/ou interstitiels.

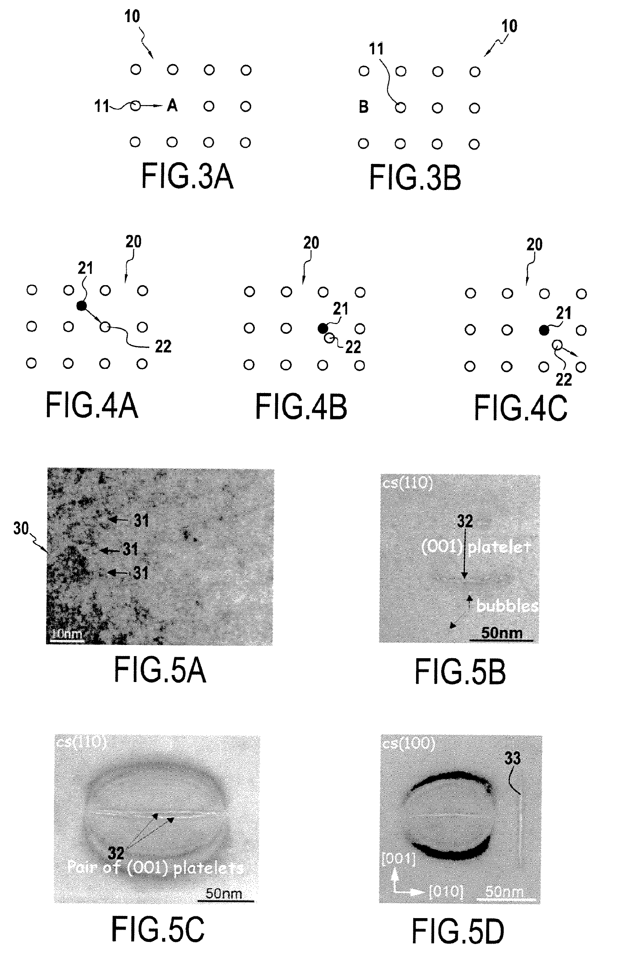

Comme illustré sur la figure 3A, un défaut ponctuel de type lacune correspond à un site A (lacune) d'un réseau cristallin 10 qui n'est pas occupé. Le mécanisme de diffusion faisant appel aux défauts ponctuels de type lacunes (mécanisme lacunaire) correspond à l'occupation d'une lacune par un atome voisin 11 qui peut "sauter" sur ce site, faisant apparaître une lacune au site qu'il vient de quitter, le site B sur la figure 3B. Par conséquent, dans une hétérostructure de type Si/SiGe, la présence de lacunes dans le réseau cristallin combinée à l'application de traitements thermiques va entraîner par un enchaînement de sauts entre les lacunes le déplacement des atomes de germanium dans la structure et réaliser ainsi leur diffusion, dite diffusion "en mode lacunaire".

Un défaut ponctuel de type interstitiel correspond à un atome interstitiel sautant de site interstitiel en site interstitiel (i.e. sites entre les sites substitutionnels du réseau cristallin). On parle dans ce cas de mécanisme interstitiel direct. Toutefois, lorsque l'atome considéré peut se trouver en position substitutionnelle et interstitielle, le mécanisme de diffusion devient un mécanisme interstitiel dit "indirect" (ou "interstitialcy"). Dans ce cas, comme illustré sur les figures 4A à 4C, quand un atome 22 d'un réseau critsallin 20 se trouve positionné en un site de substitution, il ne peut "sauter" que si un interstitiel 21 arrive en position voisine (figure 4A) et le chasse de son site (figure 4B), le mettant ainsi lui- même en position interstitielle (figure 4C). L'atome 22 peut ensuite "sauter" vers n'importe quel site substitutionnel voisin, créant de ce fait un défaut interstitiel.

Dans le document Griglione et al. :"Diffusion of Ge in Si1-xGex/Si single quantum wells in inert and oxidizing ambients", JAP, 88, 3, 1366-1372, August 2000, les auteurs ont étudié la diffusion de germanium au sein d'une hétérostructure Si/SiGe/Si dans une atmosphère oxydante et dans une atmosphère inerte (Ar/ N₂). Les résultats montrent que les profils de diffusion du germanium sont les mêmes quelles que soient la nature du milieu et la température appliquée.

D'après ce document, il semblerait que la présence de lacunes favorise majoritairement la diffusion de germanium alors que la présence d'interstitiels n'a pas de rôle majeur dans cette diffusion.

Ce phénomène de diffusion en mode lacunaire a également été observé dans des hétérostructures autres que celles de type SiGe/Si. Par exemple, dans une hétérostructure formée d'une couche d'alliage d'antimoine (Sb) par exemple SiₓSb_{y} ou d'une couche dopée à l'antimoine sur un substrat de silicium, les éléments d'antimoine diffusent presque entièrement par voie lacunaire dans le silicium. De même, dans une hétérostructure formée d'une couche d'alliage d'étain (Sn) par exemple SiₓSn_{y} ou d'une couche dopée à l'étain sur un substrat de silicium, l'étain diffuse environ de 60% à 80% en mode lacunaire dans le substrat de silicium.

D'une manière générale, la diffusion dans les métaux se fait principalement en mode lacunaire.

Dans le cas de la fabrication d'une structure, par exemple sSOI, selon la technologie Smart Cut®, l'étape d'implantation d'espèce atomique pour former une couche de fragilisation en vue du détachement de la couche implantée entraîne une augmentation du nombre de lacunes présents dans la couche. En effet, lors de l'étape d'implantation, des nano-bulles sont créées dans la couche implantée et vont évoluer en agglomérats de lacunes au cours des différents recuits appliqués lors du procédé de fabrication selon la technologie Smart Cut@ créant alors une sursaturation en lacunes dans le substrat. Dans le cas de l'implantation d'une couche de germanium, le germanium, qui diffuse principalement en "mode lacunaire", va alors se positionner dans ces lacunes pour diffuser au sein de la structure.

### Résumé de l'invention

L'invention a pour but de remédier au problème de la diffusion en mode lacunaire d'éléments au sein d'une hétérostructure.

A cet effet, l'invention propose un procédé de fabrication d'une hétérostructure comprenant au moins une première couche en matériau semi-conducteur sur une deuxième couche en un matériau différent de celui de la première couche, des éléments dudit matériau semi-conducteur étant aptes à diffuser dans la deuxième couche en mode lacunaire, caractérisé en ce qu'il comprend une étape d'implantation ionique de la première couche pour former une couche de fragilisation à une profondeur déterminée dans ladite première couche, ladite étape d'implantation entraînant la formation de lacunes dans la première couche et une étape d'enrichissement en défauts interstitiels de la première couche de manière à limiter la diffusion desdits éléments de ladite première couche, l'étape d'enrichissement étant réalisée avant ou après ladite étape d'implantation ionique.

En enrichissant, c'est-à-dire en sursaturant ainsi la couche de semi-conducteur en défauts interstitiels, on dispose d'une quantité importante d'interstitiels pour occuper les nombreux sites lacunaires supplémentaires (sursaturation) issus de l'implantation ionique destinée à former la couche de fragilisation. On empêche ainsi la diffusion par voie lacunaire des éléments du matériau semi-conducteur de la première couche dans cette couche et dans la deuxième couche adjacente, et ce même lors de traitements thermiques ultérieurs.

Selon un aspect de l'invention, la première couche est une couche de silicium-germanium (SiGe) et la deuxième couche est un substrat de silicium, l'étape d'implantation ionique étant réalisée dans la couche de SiGe pour former une couche de fragilisation à une profondeur déterminée dans ladite couche de SiGe, ladite couche de SiGe étant enrichie en défaut interstitiels lors de l'étape d'enrichissement.

En enrichissant (i.e. en sursaturant) ainsi la couche de SiGe en défauts interstitiels, on compense la sursaturation en lacunes créée par l'implantation ionique pour former la couche de fragilisation. Les interstitiels vont venir occuper les sites lacunaires et empêcher, par conséquent, la diffusion par voie lacunaire des éléments de germanium de la couche de SiGe au sein de cette couche et dans les couches adjacentes, et ce même lors de traitements thermiques ultérieurs. Par conséquent, on peut former une couche silicium contraint sur la couche de SiGe ainsi traitée sans risque de diffusion des éléments de germanium dans la couche de silicium contraint.

Selon une première mise en oeuvre de l'invention, l'étape d'enrichissement en défauts interstitiels dans la couche de SiGe peut être réalisée par implantation ionique d'atomes de silicium dans la couche de SiGe.

L'énergie d'implantation et la dose d'implantation lors de l'implantation ionique d'atomes de silicium dans la couche de SiGe sont choisies de manière à former une couche enrichie en silicium qui se situe entre la couche de fragilisation et la surface de la couche de SiGe et qui présente une concentration maximale d'atomes de silicium comprise entre 1.10²⁰ et 5.10²¹ atomes/cm³.

Selon un autre mode de mise en oeuvre de l'invention, l'étape d'enrichissement en défauts interstitiels dans la couche de SiGe peut être réalisée par oxydation de la surface de la couche de SiGe.

Le procédé de la présente invention peut être mis en oeuvre pour la formation d'une structure de type sSOI. Dans ce cas, la couche de SiGe est une couche de SiGe relaxée sur un substrat de silicium et le procédé comprend en outre:
- une étape de formation d'une couche de silicium contraint sur la couche de SiGe,
- une étape de collage de la couche de silicium contraint sur un substrat support,
- une étape de détachement par clivage de la couche de SiGe au niveau de la couche de fragilisation,
- une étape de gravure sélective du reliquat de SiGe subsistant au dessus de la couche la couche de silicium contraint après détachement.

Lorsque la formation de défauts interstitiels dans la couche de SiGe est obtenue par implantation ionique, cette implantation peut être réalisée avant ou après l'étape d'implantation permettant de former la couche de fragilisation, mais aussi avant ou après l'étape de formation de la couche de silicium contraint sur la couche de SiGe.

Lorsque la formation de défauts interstitiels dans la couche de SiGe est obtenue par oxydation de la surface de la couche de SiGe, cette oxydation peut être réalisée avant ou après l'étape de formation de la couche de silicium contraint sur la couche de SiGe et, dans tous les cas, avant l'étape d'implantation pour former la couche de fragilisation.

### Brève description des figures

- les figures 1A et 1B montrent la fabrication d'une structure de type sSOI selon la technologie Smart Cut™,
- les figures 2A à 2C montrent la diffusion du germanium au sein de la structure de type sSOI au cours de sa fabrication,
- les figures 3A à 3B illustrent un exemple du mécanisme de diffusion lié aux défauts ponctuels de type lacunes,
- les figures 4A à 4C illustrent un exemple du mécanisme de diffusion lié aux défauts ponctuels de type interstitiels,
- les figures 5A à 5D montrent la formation de nano-bulles dans une couche de silicium après implantation ionique d'hélium et leur évolution en défauts de type lacunes après application de traitements thermiques,
- les figures 6A à 6G sont des vues schématiques en coupe montrant la réalisation d'une structure de type sSOI conformément à un mode de mise en oeuvre de l'invention,
- la figure 7 est un organigramme des étapes mises en oeuvre dans les figures 6A à 6G,
- les figures 8A à 8H sont des vues schématiques en coupe montrant la réalisation d'une structure de type sSOI conformément à un autre mode de mise en oeuvre de l'invention,
- la figure 9 est un organigramme des étapes mises en oeuvre dans les figures 8A à 8H.

### Exposé détaillé de modes de réalisation de l'invention

La présente invention propose une méthode de contrôle de la diffusion en mode lacunaire d'éléments, comme par exemple des atomes de germanium, dans une couche de matériau semi-conducteur (ex. couche de silicium-germanium (SiGe)) pour restreindre le déplacement de ces éléments dans la couche de semi-conducteur et empêcher ainsi leur passage dans les couches adjacentes à la couche de semi-conducteur.

La présente invention s'applique d'une manière générale à tout type d'hétérostructures comprenant une couche en matériau semi-conducteur contenant des éléments susceptibles de diffuser en mode lacunaire dans cette couche et dans les couches adjacentes à la suite d'une implantation ionique entraînant la formation de lacunes favorisant la diffusion des éléments en mode lacunaire, par exemple lors de traitements thermiques ultérieurs. L'invention peut s'appliquer, par exemple, à des hétérostructures formées d'une couche d'alliage d'antimoine (Sb) par exemple SiₓSb_{y} ou d'une couche dopée à l'antimoine sur un substrat de silicium, ou encore à des hétérostructures formées d'une couche d'alliage d'étain (Sn) par exemple SiₓSn_{y} ou d'une couche dopée à l'étain sur un substrat de silicium

L'invention s'applique en particulier aux hétérostructures contenant au moins une couche de silicium-germanium 5SiGe) sur un substrat de silicium et dont la concentration en germanium est comprise entre 1% et 100%. Ce type de couche contient en général des défauts de type lacunes favorisant la diffusion des atomes de germanium dans la couche de SiGe ainsi que dans les couches adjacentes. De telles couches correspondent notamment aux couches de SiGe ayant subi ou destinées à subir une implantation ionique (implantation d'espèces He et/ou H) afin de former une zone de fragilisation en vue d'un clivage (fracture).

L'invention concerne notamment tout type de substrats donneurs comprenant une couche de SiGe relaxée utilisée pour la formation d'une couche de silicium contraint (sSi) et plus particulièrement à de tels substrats donneurs dont la couche de SiGe présente une teneur significative en germanium et qui sont plus sensibles à la diffusion en raison de leur plus forte concentration en germanium. La couche de SiGe dans ces substrats contient typiquement entre 20% et 50% de germanium mais cette concentration peut aller jusqu'à 100% suivant la contrainte de la couche de sSi désirée.

D'une manière générale, des défauts de type lacunes (dénommés ci-après "lacunes") mais aussi des défauts de type interstitiels (dénommés ci-après "interstitiels") sont présents au sein des couches de SiGe. Toutefois, il existe un état d'équilibre entre la concentration de lacunes Cv et la concentration d'interstitiels Ci dans un même substrat. Cet état d'équilibre peut être alors défini par la formule Cv x Ci = constante.

Lors des étapes d'implantation (par exemple une implantation d'hydrogène et/ou d'hélium), réalisées en vue de créer une zone de fragilisation pour permettre un transfert de couches selon la technologie Smart Cut™, cet équilibre est modifié. Des nano-bulles sont créées dans la couche de SiGe et vont évoluer en agglomérats de lacunes au cours des différents recuits appliqués lors du procédé de fabrication créant alors une sursaturation en lacunes dans le substrat. Le germanium qui diffuse principalement en "mode lacunaire" va alors se positionner dans ces lacunes pour diffuser au sein du substrat.

La figure 5A montre la présence d'agglomérats de lacunes 31 obtenus après implantation dans un substrat de silicium 30 d'ions hélium (conditions de l'implantation: énergie d'implantation = 32 keV, dose He = 1.10¹⁶ atomes/cm²). Les figures 5B à 5D montrent, après un recuit à 350 °C pendant 3 minutes du substrat de silicium 30 implanté, la transformation des nano-bulles en défauts de type "platelets" horizontaux 32 dans les plans {100} (plans structure cubique) (figures 5B et 5C) et en défauts de type "platelets" verticaux 33 dans les plans {010} (figure 5D).

Ces objets ("platelets"), qui sont remplis de gaz dans le premier stade de leur évolution, vont se dissoudre en émettant des lacunes. Ces objets sources de lacunes ont également été observés dans des substrats de SiGe ou de germanium.

Afin de prévenir la migration des lacunes et, par conséquent, la diffusion du germanium, la présente invention propose d'enrichir le substrat contenant la couche de SiGe en interstitiels de manière à compenser la sursaturation en lacunes par recombinaison des paires lacunes/interstitiels.

L'enrichissement du substrat en interstitiels peut être réalisé par différentes techniques.

Selon une première technique, l'enrichissement est réalisé par implantation ionique.

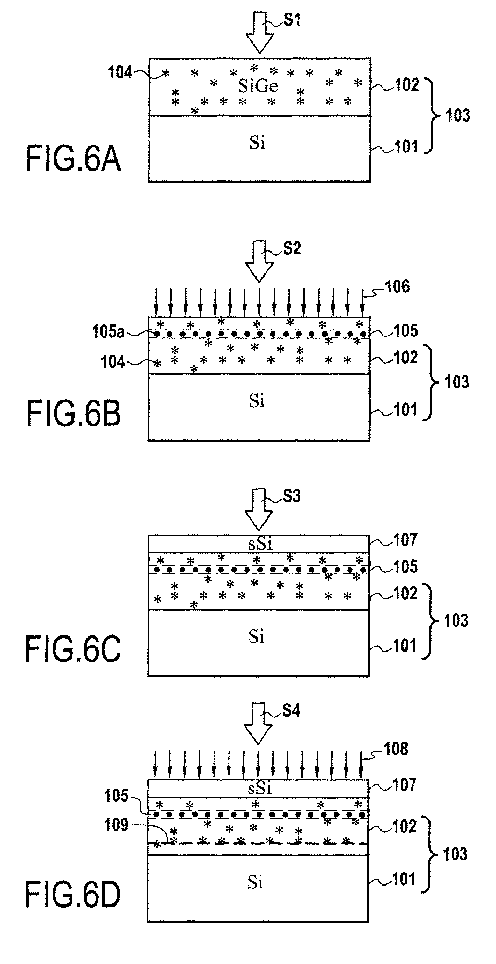

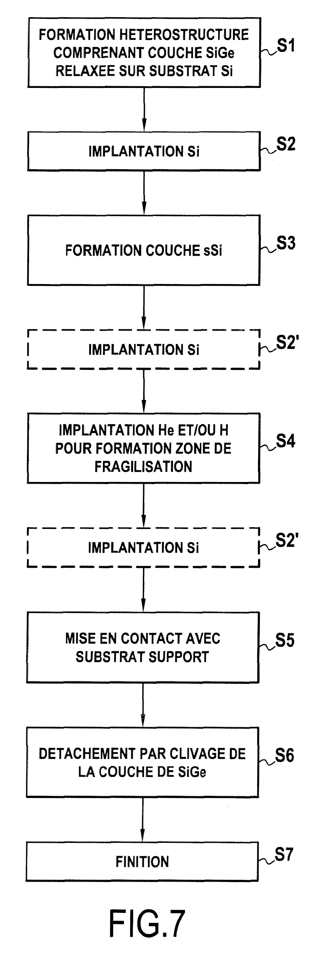

Les figures 6A à 6G et 7 décrivent une mise en oeuvre de cette première technique appliquée lors de la réalisation d'une plaque ("wafer") de type sSOI par la technologie Smart Cut™.

La première étape (étape S1) consiste à former une structure hétérogène 103, représentée en figure 6A, comprenant un substrat support 101 en silicium et une couche de SiGe relaxée 102 formée à partir d'une couche tampon de SiGe (non représentée). La réalisation d'une telle structure hétérogène est bien connue en soi et ne sera décrite plus en détail par souci de simplification. La couche 102 comprend une quantité d'éléments de germanium 104 correspondant par exemple entre 20% et 50% de la composition de la couche de SiGe 102. L'épaisseur de la couche de SiGe est comprise entre 0,1 et 1 micromètre.

Conformément à l'invention, des éléments sont implantés de manière à enrichir une zone se situant entre le maximum d'implantation formant la zone de fragilisation pour le clivage (formée ultérieurement à l'étape S4) et l'interface entre la couche de SiGe et celle de sSi. La dose des éléments implantés est contrôlée pour ne pas rendre le substrat amorphe et éviter sa relaxation. Dans cette étape (figure 6B) (étape S2), on réalise par exemple une implantation ionique 106 d'atomes de silicium 105a (i.e. implantation d'atomes de silicium ionisés) afin d'obtenir une concentration maximale d'atomes de silicium comprise entre 1.10²⁰ et 5.10²¹ atomes/cm³ au voisinage de la zone de maximum d'implantation 105.

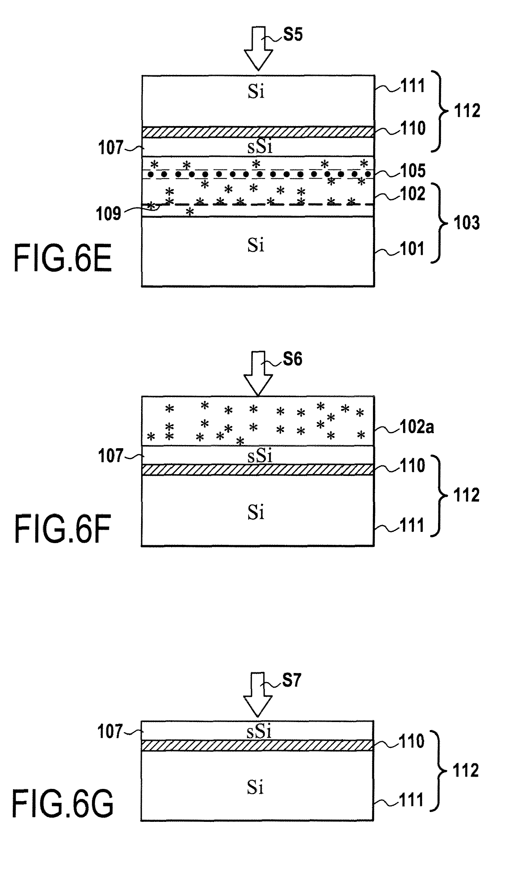

On forme ensuite une couche de silicium contraint 107 sur la couche 102, par exemple par épitaxie (figure 6C) (étape S3). Conformément à la technologie Smart Cut™ bien connue, une implantation 108, par exemple d'hélium et/ou hydrogène, est réalisée dans la couche de SiGe 102 pour former une zone de fragilisation 109 (figure 6D) (étape S4). La surface de la couche de sSi 107 est alors mise en contact intime, par exemple par collage, avec un substrat support ou receveur 112 comprenant un substrat de base 111 par exemple en silicium avec une couche d'oxyde enterré 110 (BOX) formant la couche isolante (figure 6E) (étape S5). Alternativement, ou en complément, la couche d'oxyde peut être formée par dépôt sur la couche de sSi 107. L'épaisseur de la couche d'oxyde enterré ("buried oxide" (BOX)) varie typiquement entre 500 et 1600 angströms, et de préférence entre 1300 et 1500 angströms.

On procède ensuite au détachement par clivage ("splitting") de la couche de SiGe 102 au niveau de la zone fragilisée 109 par l'implantation d'hélium et/ou d'hydrogène, laissant subsister un reliquat 102a de la couche 102 situé entre la zone de fragilisation 109 et l'interface couche SiGe 102/couche sSi 107 (figure 6F, étape S6). Le clivage peut être notamment provoqué par un recuit à 500 °C effectué sur une durée de 30 minutes environ.

Une étape de finition permettant de retirer le reliquat 102a de SiGe (par gravure sélective, polissage/planarisation, etc.) et de conférer un bon état de surface à la couche de sSi est réalisée (figure 6G, étape S7). Elle peut comprend en outre la formation d'une couche isolante sur la couche de sSi. L'étape de finition comprend aussi notamment un recuit de stabilisation à 800 °C effectué sur une durée variant de 30 minutes à 1 heure.

L'implantation 106 (étape S2) peut être également réalisée après l'étape de formation de la couche de silicium contraint 107 sur la couche 102 (étape S2' sur la figure 7), ou après l'étape d'implantation 108 d'hélium et/ou hydrogène réalisée dans la couche de SiGe 102 pour former la zone de fragilisation 109 (étape S2" sur la figure 7).

L'implantation 106 (étape S2, S2' ou S2") consiste en une implantation d'atomes de silicium réalisée à une énergie d'implantation comprise entre 10 et 150 keV pour une dose d'implantation comprise entre 5.10¹⁴ et 5.10¹⁵ atomes/cm².

En enrichissant ainsi la couche de SiGe 102 en défauts interstitiels par l'implantation d'atome de silicium, on empêche la diffusion des éléments de germanium au sein de la couche de SiGe et, par conséquent, leur passage dans la couche de sSi 107. La sélectivité de la gravure du reliquat de couche de SiGe est de ce fait sensiblement augmentée, ce qui permet de limiter significativement l'apparition de défauts et la dégradation de l'état de surface de la couche de sSi après gravure.

Selon une deuxième technique, l'enrichissement en interstitiels de la couche de SiGe est réalisé par une étape d'oxydation de la surface du substrat. La réaction d'oxydation du substrat comprenant la couche de SiGe va provoquer l'injection d'atomes de silicium interstitiels depuis la surface, permettant ainsi une recombinaison des lacunes créées par l'implantation d'hélium et/ou d'hydrogène (création zone de fragilisation pour clivage) avec ces interstitiels et éviter une diffusion du Ge par voie lacunaire.

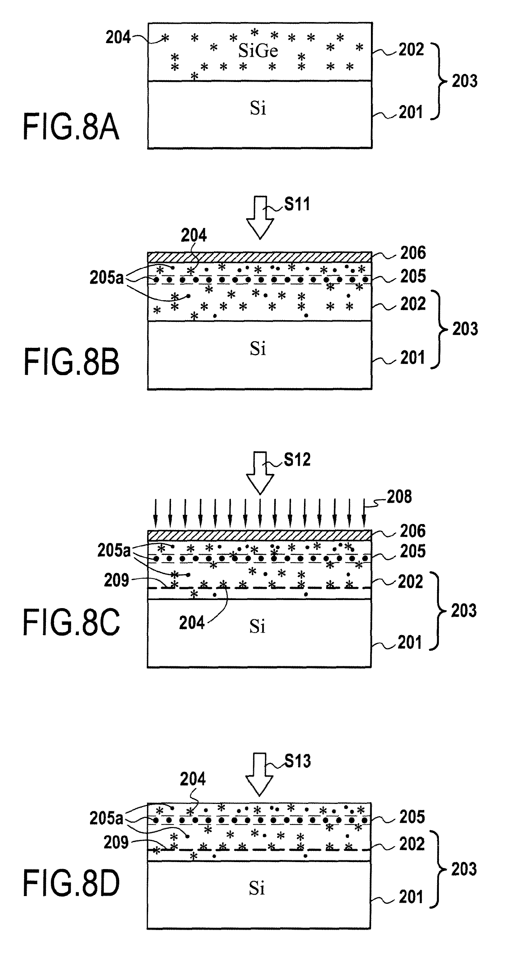

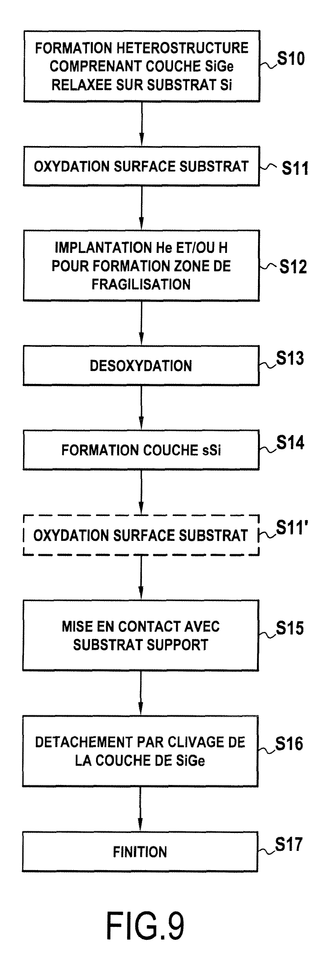

Les figures 8A à 8H et 9 décrivent une mise en oeuvre de cette deuxième technique appliquée lors de la réalisation d'une plaque ("wafer") de type sSOI par la technologie Smart Cut™.

La première étape (étape S10) consiste à former une structure hétérogène 203, représentée en figure 8A, comprenant un substrat support 201 en silicium et une couche de SiGe relaxée 202 formée à partir d'une couche tampon de SiGe (non représentée). La réalisation d'une telle structure hétérogène est bien connue en soi et ne sera décrite plus en détail par souci de simplification. La couche 202 comprend une quantité d'éléments de germanium 204 correspondant par exemple entre 20% et 50% de la composition de la couche de SiGe 202. L'épaisseur de la couche de SiGe est comprise entre 0,1 et 1 micromètre.

Conformément à l'invention, on réalise une oxydation de la surface de la couche de SiGe 202 de manière à injecter des atomes de silicium interstitiels 205a et à sursaturer la couche avec ces atomes de silicium interstitiels dans une zone 205, ces derniers étant destinés à capter les lacunes introduites lors de l'étape d'implantation ionique (figure 8B) (étape S11). Une fine couche d'oxyde 206 est alors formée à la surface de la couche de SiGe 202.

Dans cette étape, l'oxydation du substrat ou hétérostructure 203 peut être réalisée, par exemple, au moyen d'un recuit effectué entre 350 °C et 450 °C sous flux d'oxygène et sur une durée pouvant varier entre 10 minutes et 1 heure. Une telle oxydation permet d'injecter une dose équivalente d'atomes de silicium interstitiels comprise entre 1.10¹³ et 1.10¹⁴ atomes/cm³.

Selon la technologie Smart Cut™ bien connue, une implantation 208 d'hélium et/ou hydrogène est réalisée dans la couche de SiGe 202 pour former une zone de fragilisation 209 (figure 8C) (étape S12).

Dans le cas où l'étape d'oxydation est réalisée avant la formation de la couche contrainte de silicium, après le traitement thermique de formation d'oxyde, une étape de désoxydation est mise en oeuvre (par trempage dans un bain d'acide fluorhydrique (HF) par exemple) pour éliminer la fine couche d'oxyde 206 formée à la surface de la couche 202 (figure 8D) (étape S13).

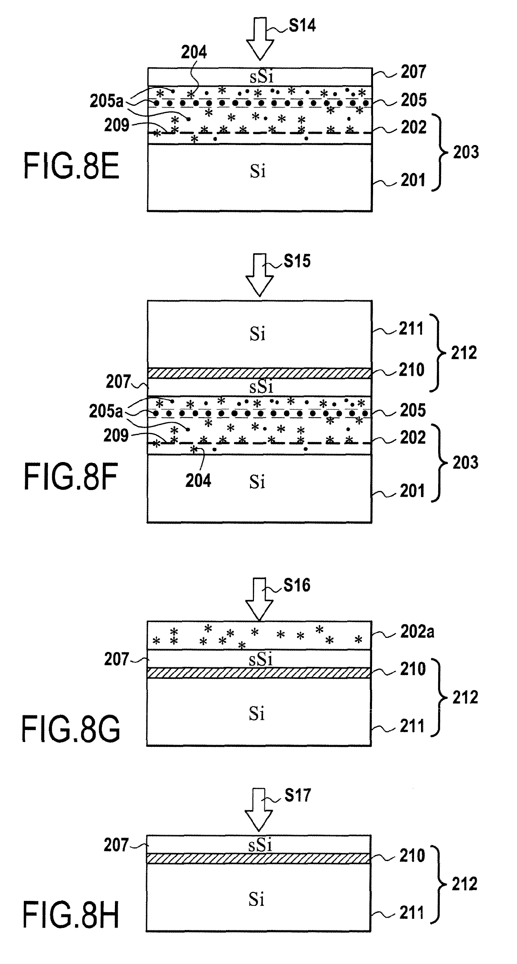

On forme ensuite une couche de silicium contraint 207 sur la couche 202, par exemple par épitaxie (figure 8E) (étape S14).

La surface de la couche de sSi 207 est alors mise en contact intime, par exemple par collage, avec un substrat support ou receveur 212 comprenant un substrat de base 211 par exemple en silicium avec une couche d'oxyde enterré 210 ("buried oxide" (BOX)) formant la couche isolante (figure 8F) (étape S15). Alternativement, ou en complément, la couche d'oxyde peut être formée par dépôt sur la couche de sSi 207. L'épaisseur de la couche d'oxyde enterré (BOX) varie typiquement entre 500 et 1600 angströms, et de préférence entre 1300 et 1500 angströms.

On procède ensuite au détachement par clivage ("splitting") de la couche de SiGe 202 au niveau de la zone fragilisée 209 par l'implantation d'hélium et/ou d'hydrogène, laissant subsister un reliquat 202a de la couche 202 situé entre la zone de fragilisation 209 et l'interface couche SiGe 202/couche sSi 207 (figure 8G, étape S16). Le clivage peut être notamment provoqué par un recuit à 500 °C sur une durée de 30 minutes.

Une étape de finition permettant de retirer le reliquat 202a de SiGe (par gravure chimique sélective, polissage/planarisation, etc.) et de conférer un bon état de surface à la couche de sSi est réalisée (figure 8H, étape S17). Elle peut comprend en outre la formation d'une couche isolante sur la couche de sSi. L'étape de finition comprend aussi notamment un recuit de stabilisation à 800 °C effectué sur une durée variant de 30 minutes à 1 heure.

L'étape d'oxydation (étape S11) peut également être réalisée après l'étape de formation de la couche de silicium contraint 207 sur la couche 202 (étape S11' sur la figure 9). Dans ce cas et contrairement à celui où l'oxydation est réalisée avant la formation de la couche de sSi 207, l'étape de désoxydation (étape S13) n'est pas nécessaire, une couche isolante, correspondant à un oxyde enterré (BOX) dans la structure finale, étant déposée ultérieurement.

Les atomes de Si injectés lors de l'étape S11 (ou S11') vont se placer en interstitiels puis se recombiner avec les lacunes présentes au voisinage de l'implantation d'hélium et/ou d'hydrogène. Cela permet de diminuer le flux des lacunes au niveau de l'interface entre la couche de SiGe et la couche de sSi et, par conséquent, de diminuer la diffusion après l'application de traitements thermiques ultérieurs (par exemple formation couche oxyde, recuit de splitting, de stabilisation, etc.).

En enrichissant ainsi la couche de SiGe 202 en défauts interstitiels par oxydation, on empêche la diffusion des éléments de germanium au sein de la couche de SiGe et, par conséquent, leur passage dans la couche de sSi 207. La sélectivité de la gravure du reliquat de couche de SiGe est de ce fait sensiblement augmentée, ce qui permet de limiter significativement l'apparition de défauts et la dégradation de l'état de surface de la couche de sSi après gravure.

## Revendications

1. Procédé de fabrication d'une hétérostructure comprenant au moins une première couche en matériau semi-conducteur sur une deuxième couche en un matériau différent de celui de la première couche, des éléments dudit matériau semi-conducteur étant aptes à diffuser dans la deuxième couche en mode lacunaire, **caractérisé en ce qu'**il comprend une étape d'implantation ionique de la première couche pour former une couche de fragilisation à une profondeur déterminée dans ladite première couche, ladite étape d'implantation entraînant l'apparition de lacunes dans la première couche et une étape d'enrichissement en défauts interstitiels de la première couche de manière à limiter la diffusion en mode lacunaire desdits éléments de ladite première couche, l'étape d'enrichissement étant réalisée avant ou après ladite étape d'implantation ionique.

2. Procédé selon la revendication 1, **caractérisé en ce que** la première couche est une couche de silicium-germanium (SiGe) (102) et la deuxième couche est un substrat de silicium (101), l'étape d'implantation ionique (108) étant réalisée dans la couche de SiGe (102) pour former une couche de fragilisation (109) à une profondeur déterminée dans ladite couche de SiGe, ladite couche de SiGe (102) étant enrichie en défaut interstitiels.

3. Procédé selon la revendication 2, **caractérisé en ce que** l'étape d'enrichissement en défauts interstitiels de la couche de SiGe (102) est réalisée par implantation ionique (106) d'atomes de silicium (105a) dans la couche de SiGe.

4. Procédé selon la revendication 3, **caractérisé en ce que** l'énergie d'implantation et la dose d'implantation lors de l'implantation ionique (106) d'atomes de silicium dans la couche de SiGe sont choisies de manière à former une couche enrichie (105) en silicium située entre la couche de fragilisation (109) et la surface de la couche de SiGe (102).

5. Procédé selon la revendication 4, **caractérisé en ce que** la zone enrichie (105) en silicium présente une concentration maximale d'atomes de silicium comprise entre 1.10²⁰ et 5.10²¹ atomes/cm³.

6. Procédé selon l'une quelconque des revendications 3 à 5, **caractérisé en ce que** l'implantation ionique (106) d'atomes de silicium dans la couche de SiGe est réalisée à une énergie d'implantation comprise entre 10 et 150 keV pour une dose d'implantation comprise entre 5.10¹⁴ et 5.10¹⁵ atomes/cm².

7. Procédé selon la revendication 2, **caractérisé en ce que** l'étape d'enrichissement en défauts interstitiels dans la couche de SiGe (202) est réalisée par oxydation de la surface de la couche de SiGe.

8. Procédé selon la revendication 7, **caractérisé en ce que** l'oxydation de la surface de la couche de SiGe (202) est réalisée au moyen d'un recuit effectué entre 350 °C et 450 °C sous flux d'oxygène et sur une durée pouvant varier entre 10 minutes et 1 heure.

9. Procédé selon la revendication 7 ou 8, **caractérisé en ce qu'**il comprend en outre, après l'oxydation de la surface de la couche de SiGe (202), une étape de désoxydation pour éliminer la couche d'oxyde (206) formée à la surface de la couche de SiGe.

10. Procédé selon l'une quelconque des revendications 2 à 9, **caractérisé en ce que** la couche de SiGe (102 ; 202) est une couche de SiGe relaxée sur un substrat de silicium, ledit procédé comprend en outre:
- une étape de formation d'une couche de silicium contraint (107 ; 207) sur la couche de SiGe (102 ; 202),
- une étape de collage de la couche de silicium contraint (107 ; 207) sur un substrat support (112 , 212),
- une étape de détachement par clivage de la couche de SiGe (102 ; 202) au niveau de la couche de fragilisation (109 ; 209),

11. Procédé selon la revendication 10, **caractérisé en ce que** l'implantation ionique (106) d'atomes de silicium est réalisée avant ou après l'étape d'implantation pour former la couche de fragilisation (109).

12. Procédé selon la revendication 10 ou 11, **caractérisé en ce que** l'implantation ionique (106) d'atomes de silicium est réalisée avant ou après l'étape de formation de la couche de silicium contraint (107) sur la couche de SiGe (102).

13. Procédé selon la revendication 10, **caractérisé en ce que** l'oxydation de la surface de la couche de SiGe (202) est réalisée avant ou après l'étape de formation de la couche de silicium contraint (207) sur la couche de SiGe et avant l'étape d'implantation pour former la couche de fragilisation.

14. Procédé selon l'une quelconque des revendications 10 à 13, **caractérisé en ce que** l'étape de détachement par clivage de la couche de SiGe (102 ; 202) au niveau de la couche de fragilisation (109 ; 209) comprend un recuit réalisé à une température d'environ 500 °C sur une durée 30 minutes.

15. Procédé selon l'une quelconque des revendications 10 à 14, **caractérisé en ce qu'**une couche isolante est formée sur la couche de silicium contraint.

16. Procédé selon l'une quelconque des revendications 10 à 15, **caractérisé en ce qu'**il comprend en outre une étape de recuit de stabilisation réalisé à une température d'environ 800 °C sur une durée comprise entre 30 minutes et 1 heure.

17. Procédé selon l'une quelconque des revendications 10 à 16, **caractérisé en ce que** la couche de SiGe (102, 202) présente une épaisseur comprise entre 0.1 et 1 micromètres et une concentration en germanium comprise entre 20% et 50%.

18. Procédé selon l'une quelconque des revendications 10 à 17, **caractérisé en ce qu'**il comprend en outre, après l'étape de détachement par clivage de la couche de SiGe (102 ; 202) au niveau de la couche de fragilisation (109 ; 209), une étape de gravure sélective du reliquat de SiGe (102a, 202a) subsistant au dessus de la couche la couche de silicium contraint (107 ; 207).
